# FASCICULE DE BREVET EUROPEEN

(11) **EP 3 065 180 B1**
(45) Date de publication et mention de la délivrance du brevet: **28.06.2023**
(21) Numéro de dépôt: 16158279.6
(22) Date de dépôt: 02.03.2016
(51) Int. Cl.: H01L 29/08, H01L 21/285, H01L 21/768, H01L 21/336, H01L 29/417

(54) **TRANSISTOR À CONNEXIONS MIS ET PROCÉDÉ DE FABRICATION**
TRANSISTOR MIT MIS-ANSCHLÜSSEN, UND HERSTELLUNGSVERFAHREN
TRANSISTOR WITH MIS CONNECTIONS AND MANUFACTURING METHOD

(30) Priorité: 03.03.2015 FR 1551765
(43) Date de publication de la demande: 07.09.2016
(73) Titulaire: Commissariat à l'Énergie Atomique et aux Énergies Alternatives, 75015 Paris (FR)
(72) Inventeur: BORREL, Julien, 38170 SEYSSINET (FR); HUTIN, Louis, 38950 SAINT MARTIN LE VINOUX (FR); MORAND, Yves, 38000 GRENOBLE (FR); NEMOUCHI, Fabrice, 38430 MOIRANS (FR); NIEBOJEWSKI, Heimanu, 38000 GRENOBLE (FR)
(74) Mandataire: INNOV-GROUP

(56) Documents cités:
- WO-A2-2012/087660
- US-A1- 2013 069 126
- US-A1- 2014 308 812
- US-B1- 6 303 493
- US-B1- 6 383 878
- Randy W Mann ET AL: "Silicides and local interconnections for high-performance VLSI applications", IBM Journal of Research and Development, 1 juillet 1995 (1995-07-01), pages 403-417, XP055232629, Armonk DOI: 10.1147/rd.394.0403 Extrait de l'Internet: URL:http://web.stanford.edu/class/ee311/NO TES/IBM_Silicides_Mann.pdf [extrait le 2015-12-01]
- COSS B ET AL: "Near band edge Schottky barrier height modulation using high-Î dielectric dipole tuning mechanism", APPLIED PHYSICS LETTERS, AMERICAN INSTITUTE OF PHYSICS, 2 HUNTINGTON QUADRANGLE, MELVILLE, NY 11747, vol. 95, no. 22, 2 décembre 2009 (2009-12-02), pages 222105-222105, XP012126636, ISSN: 0003-6951, DOI: 10.1063/1.3263719

## Description

L'invention concerne la formation des contacts entre le métal des contacts de connexion et la source et le drain d'un transistor de type MOS, et en particulier la formation de connexions entre métal et semi-conducteur permettant une résistance de contact d'interface minimale pour le transistor, et plus globalement une résistance d'accès réduite.

Afin de diminuer le coût des circuits intégrés et d'augmenter leurs performances, les fabricants ont constamment réduit la taille des transistors, augmenté leur nombre par puce, et augmenté le nombre de circuits réalisés en parallèle. Pour permettre cette augmentation de performances des circuits intégrés, les technologues ont donc diminué géométriquement les dimensions des transistors de la partie active ainsi que les dimensions des interconnexions. Cependant, ces améliorations ont pour conséquence une amplification des effets parasites liés aux transistors, aux connexions et aux interconnexions.

La résistance parasite externe devient un problème majeur pour la poursuite de la réduction de taille des noeuds technologiques. La résistance de contact ou de connexion entre le métal et le semi-conducteur devient notamment un facteur de limitation important pour les futurs noeuds technologiques, qui induisent une diminution de la surface de contact.

Un procédé connu pour former une connexion ou un contact entre le métal et le semi-conducteur consiste à déposer un métal de contact sur le drain et la source. On procède alors à la formation d'un composé intermétallique entre le semi-conducteur de la source ou du drain et le métal, en vue de diminuer les résistances de contact.

Avec des sources et drains réalisés par exemple en SiGe dopé B pour le PMOS et en SiC dopé As pour le NMOS, le contrôle des propriétés d'un composé intermétallique avec un métal de contact de type NiPt est délicat. En particulier, son état d'interface, sa stabilité en température ou l'homogénéité de son épaisseur sont délicats à maîtriser.

En vue de répondre à ces problématiques, il a été proposé de réaliser une connexion par un contact à base de diélectrique généralement désigné par l'acronyme MIS. Il a ainsi été constaté qu'une couche ou bicouche diélectrique entre le métal d'interconnexion et le semi-conducteur permettait la réalisation de connexions ou contacts non alliés tout en contrôlant la hauteur de barrière Schottky formée au sein du semi-conducteur.

La diminution de la densité d'états d'interface induite par l'insertion du diélectrique permet le relâchement de l'ancrage du niveau de Fermi et donc de réduire la hauteur de barrière Schottky.

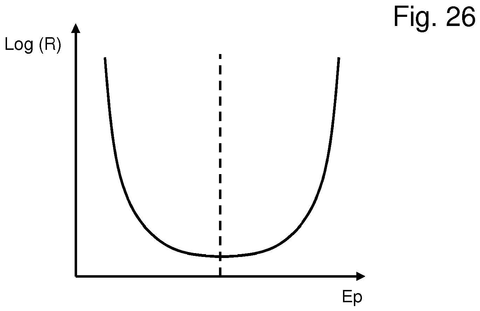

Cependant, cette insertion engendre en contrepartie une résistance tunnel dépendante de son épaisseur. Une épaisseur optimale est donc atteinte quand la compétition entre ces deux phénomènes conduit à la résistance spécifique la plus faible possible, comme illustré par le diagramme de principe de la figure 26. La figure 26 illustre la résistance de contact en fonction de l'épaisseur de la couche de diélectrique. Dans la partie gauche, l'influence de la densité d'états d'interface est prépondérante sur cette résistance. Dans la partie droite, la résistance tunnel est prépondérante.

L'énergie qui sépare la bande de valence de la bande de conduction est usuellement appelée le gap d'énergie. Afin d'évaluer cette épaisseur optimale, deux paramètres prépondérants doivent être pris en compte: le gap d'énergie du diélectrique, et le décalage entre la bande de valence du diélectrique et la bande de valence du semi-conducteur si celui-ci est de type p, ou le décalage entre la bande de conduction du diélectrique et la bande de conduction du semi-conducteur si celui-ci est de type n.

Le gap d'énergie du diélectrique détermine le degré de relâchement de l'ancrage du niveau de Fermi. A épaisseur donnée, plus sa valeur est élevée plus ce dernier sera relâché. Le décalage des bandes de conduction ou de valence détermine la résistance tunnel induite par le diélectrique. Plus sa valeur est élevée plus la résistance tunnel est importante.

Sur une source et un drain de type n, il est notamment connu d'utiliser un diélectrique de 1,2nm de La₂O₃. Sur une source et un drain de type p, il est notamment connu d'utiliser un diélectrique de 1,1 nm de TiO₂.

Pour réduire encore la résistance de connexion ou de contact, il a été proposé de réaliser une connexion par l'intermédiaire d'une double couche diélectrique généralement désignée par l'acronyme MIIS.

L'ajout d'une double couche d'oxyde comme diélectrique permet une réduction et/ou l'inversion de la hauteur de barrière Schottky sous l'effet de dipôles induits par l'interface oxyde/oxyde, ce qui aboutit à une réduction de la résistance de contact.

Lorsque deux oxydes sont accolés et présentent des densités surfaciques d'oxygène différentes, une diffusion d'anions O²⁻ s'effectue sous l'effet du gradient de concentration d'oxygène. Ces anions laissent derrière eux des lacunes Vo²⁺. Des charges de signes opposés sont donc générées de part et d'autre de l'interface entre les couches d'oxyde, créant ainsi des dipôles pouvant réduire la hauteur de barrière Schottky.

Deux familles de bicouches peuvent être considérées :
- L'association du SiO₂ avec des oxydes ayant une densité surfacique d'oxygène supérieure conduit à l'apparition de dipôles dits de «type p» permettant une réduction de la hauteur de barrière Schottky sur les semiconducteurs de type p.
- L'association du SiO₂ avec des oxydes ayant une densité surfacique d'oxygène inférieure conduit à l'apparition de dipôles dits de «type n» permettant une réduction de la hauteur de barrière Schottky sur les semiconducteurs de type n.

Pour réduire la résistance d'accès dans la source et le drain, il est également connu de procéder à leur siliciuration. La siliciuration peut cependant affecter le canal du transistor et pose de nombreux problèmes d'industrialisation, en particulier pour des noeuds technologiques de 28nm et moins, et en particulier pour des technologies FDSOI. Pour des transistors à effet de champ, on peut donc être amené à utiliser des source et drain non siliciurés. Du fait des dispersions des étapes de photolithographie du processus de fabrication du transistor, les règles de conception impliquent de conserver un certain écartement entre l'empilement de grille et les contacts métalliques de la source et du drain. Cette distance rallonge la longueur de conduction à travers une source et un drain non siliciurés, ce qui induit une résistance d'accès non négligeable entre le canal et la source et le drain.

Le document US2014/0308812 décrit un dispositif et un procédé de fabrication d'une structure d'interconnexion pour des contacts ohmiques de transistors. Des contacts MIS sont formés sur la source et le drain.

Le document publié par Randy W Mann, intitulé « Silicides and local interconnections for high-performance VLSI applications » dans IBM Journal of Research and Development, le premier juillet 1995, aux pages 403-417, décrit des exemples de processus de formation d'interconnexions pour des transistors.

Le document publié par Coss, intitulé « Near band edge Schottky barrier height modulation using high-Î dielectric dipole tuning mechanism", dans Applied Phusics letters, American institute of Physics, volume 95 N°22, pages 222105-222105, décrit des couches diélectriques interfaciales, pour former des contacts MIS de source et de drain. Le document US 6383878 B1 divulgue un transistor à effet de champ avec des contacts en siliciure sur les régions de la source et du drain et - au moins partiellement - sur la grille.

Il existe donc un besoin pour un transistor à effet de champ et un procédé de fabrication associé permettant d'assurer des résistances de contact et d'accès réduites. L'invention vise à résoudre un ou plusieurs de ces inconvénients. L'invention porte ainsi sur un transistor à effet de champ, tel que défini dans les revendications annexées.

L'invention porte également sur un procédé de fabrication d'un transistor à effet de champ, tel que défini dans les revendications annexées.

L'homme du métier comprendra que chacune des caractéristiques des revendications dépendantes peut être combinée indépendamment aux caractéristiques des revendications indépendantes, sans pour autant constituer une généralisation intermédiaire.

D'autres caractéristiques et avantages de l'invention ressortiront clairement de la description qui en est faite ci-après, à titre indicatif et nullement limitatif, en référence aux dessins annexés, dans lesquels :
- la figure 1 est une vue en coupe d'un exemple d'un premier mode de réalisation d'un transistor FDSOI selon l'invention ;
- les figures 2 à 16 sont des vues en coupe schématiques du transistor de la figure 1 à différentes étapes d'un exemple de procédé de fabrication ;
- la figure 17 est une vue en coupe d'un exemple d'un deuxième mode de réalisation d'un transistor FDSOI selon l'invention ;
- les figures 18 à 25 sont des vues en coupe schématiques du transistor de la figure 17 à différentes étapes d'un exemple de procédé de fabrication ;
- la figure 26 est un diagramme illustrant un exemple de résistivité d'une connexion de type MIS en fonction de son épaisseur.

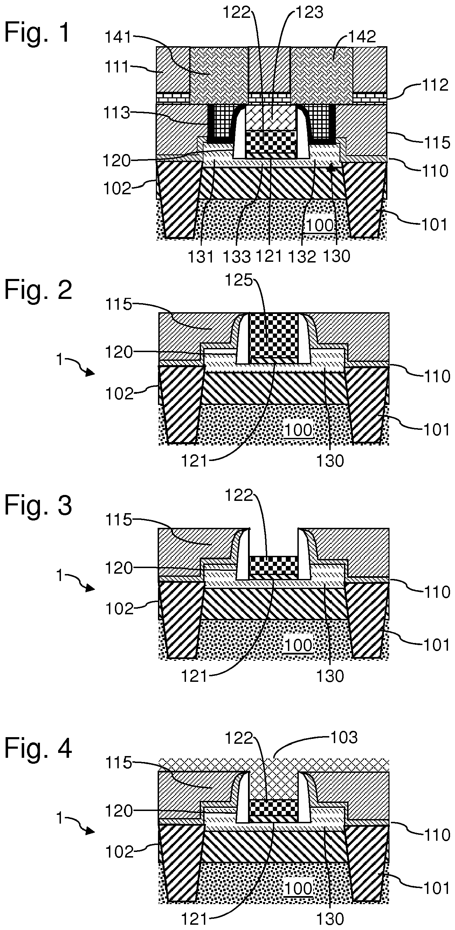

La figure 1 est une vue en coupe d'un exemple de transistor 1 de type FDSOI selon un exemple d'un premier mode de réalisation de l'invention. Le transistor 1 comporte de façon connue en soi un substrat semi-conducteur 100 surmonté par une couche d'isolant enterrée 102.

La couche d'isolant enterrée 102 est surmontée par un élément semi-conducteur 130 à base de silicium. L'élément semi-conducteur 130 est typiquement ménagé dans une couche semi conductrice usuellement désignée par le terme de couche active. Une source 131, un drain 132 et un canal 133 sont ménagés dans l'élément 130. Le canal 133 s'étend entre la source 131 et le drain 132. Pour un transistor 1 de type FDSOI, le canal 133 présente un dopage typiquement inférieur à 5*10¹⁵cm⁻³, et typiquement de l'ordre de 10¹⁵cm⁻³. Le canal 133 présente par exemple une épaisseur comprise entre 3 et 15 nm.

Le transistor 1 comporte un empilement de grille disposé au-dessus du canal 133. L'empilement de grille comporte :
- un isolant électrique de grille 121 ;
- une électrode métallique de grille 122, l'isolant électrique 121 étant disposé entre l'électrode 122 et le canal 133 ;
- un isolant électrique 123 de protection de l'électrode de grille 122, cet isolant 123 recouvrant l'électrode de grille 122.

Des espaceurs 120 sont avantageusement disposés de part et d'autre latéralement par rapport à l'isolant électrique de grille 121, par rapport à l'électrode de grille 122 et par rapport à l'isolant de protection 123.

Des contacts métalliques 141 et 142 sont disposés respectivement à l'aplomb de la source 131 et du drain 132. Les contacts métalliques 141 et 142 s'étendent en continu jusqu'à l'aplomb de l'empilement de grille. Dans le mode de réalisation illustré, les contacts métalliques 141 et 142 sont disposés au moins partiellement à l'aplomb d'espaceurs 120 respectifs.

Une couche d'isolant électrique 113 est ici disposée entre le contact métallique 141 et la source 131 d'une part, et entre le contact métallique 142 et drain 132 d'autre part.

L'isolant de protection 123 permet d'éviter un court-circuit entre l'électrode de grille 122 et le contact 141 ou le contact 142, et ce malgré que ces contacts 141 et 142 s'étendent à l'aplomb de l'empilement de grille. Ainsi, le fonctionnement du transistor 1 n'est pas altéré par d'éventuelles dispersions de positionnement des contacts 141 et 142 par rapport à l'empilement de grille. Le positionnement des contacts 141 et 142 garantit des distances minimales entre le canal 133 d'une part et la source 131 et le drain 132 d'autre part, ce qui permet de réduire la résistance de conduction et donc la résistance d'accès du transistor 1.

Ainsi, même en utilisant une source 131 et un drain 132 non siliciurés (et présentant ainsi une résistivité potentiellement très supérieure à celle d'un drain ou d'une source siliciurés), le gain de résistance de contact obtenu par l'intermédiaire de l'isolant 113 reste significatif. Par ailleurs, la présence de l'isolant 113 permet d'éviter une formation de composés intermétalliques dans la source 131 et le drain 132 par diffusion du métal des contacts 141 et 142.

Par ailleurs, on peut noter que les transistors ainsi formés présentent des dispersions relativement réduites concernant la résistance de conduction (contribuant à la résistance d'accès entre leurs contacts et le canal). En effet, quel que soit l'ampleur de la superposition d'un contact sur l'empilement de grille, la distance de conduction à travers la source ou le drain reste identique car elle est définie par la position du bord externe d'un espaceur contre lequel est formé leur contact.

En utilisant une source 131 et un drain 132 non siliciurés, le procédé de fabrication du transistor 1 est plus facilement industrialisable, du fait d'une réduction du nombre de matériaux différents à utiliser, qui sont délicats à gérer pour des transistors de dimensions très réduites.

Selon l'invention, la couche d'isolant électrique 113 recouvre au moins partiellement l'empilement de grille. L'isolant électrique 113 recouvre ici la partie supérieure des espaceurs 120, sans recouvrir intégralement l'isolant de protection 123.

L'isolant électrique 113 peut être adapté à des connexions de type MIIS, en comportant de façon connue en soi deux films isolants (non détaillés dans les figures) en matériaux différents et superposés.

Ce premier mode de réalisation vise à réduire au maximum les capacités parasites au niveau des contacts 141 et 142, en limitant la surface latérale couverte par l'isolant électrique 113.

Le transistor 1 comporte optionnellement des tranchées d'isolation 101 disposées de part et d'autre de l'ensemble comprenant la source 131, le drain 132 et l'empilement de grille. Les tranchées d'isolation 101 sont utilisées pour isoler le transistor 1 de circuits environnants. Les tranchées d'isolation 101. fréquemment désignées par l'acronyme STI, traversent ici la couche isolante enterrée 102 et s'étendent jusque dans le substrat 100. Les tranchées d'isolation 101 sont par exemple réalisées en oxyde de silicium.

Une couche d'arrêt de gravure 110 recouvre ici les bords de l'élément 130. La couche d'arrêt de gravure 110 s'étend ici sur les tranchées d'isolation 101, et jusqu'à la partie supérieure de l'élément semi-conducteur 130. La couche d'arrêt de gravure 110 présente une composition connue en soi. La couche d'arrêt de gravure 110 peut par exemple être réalisée en SiN. Cette couche 110 peut par exemple présenter une épaisseur comprise entre 5nm et 100nm, typiquement de 20nm. Le transistor 1 comporte ici une couche d'encapsulation 115 recouvrant la couche d'arrêt de gravure 110. Le transistor 1 comporte ici en outre une couche d'arrêt de gravure 112 disposée sur l'empilement de grille et la couche d'encapsulation 115. Une couche d'encapsulation 111 est disposée sur la couche d'arrêt de gravure 112.

L'isolant électrique 113 est ici en contact avec des faces latérales délimitées dans la couche d'encapsulation 115. L'isolant électrique 113 est ici également en contact avec une bordure latérale de la couche d'arrêt de gravure 110.

L'empilement de grille présente par exemple une hauteur comprise entre 10 et 100nm, par exemple de 30nm.

L'isolant de grille 121 présente typiquement une épaisseur comprise entre 0,5 et 8nm, de préférence entre 1 et 3nm, par exemple 2nm. L'isolant de grille 121 est par exemple réalisé en oxyde de silicium.

L'électrode de grille 122 présente par exemple une superposition d'une couche de polysilicium (par exemple du polysilicium GF choisi dans le groupe comprenant le NiSi, le NiPtSi, le NiCoSi, le TiSi₂ et le WSi) et d'une couche métallique pour une intégration de type grille en premier (désigné par le terme gate first en langue anglaise) ou par exemple une couche métallique pour une intégration de type grille en dernier (désigné par le terme gate last en langue anglaise). Le métal de l'électrode 122 peut par exemple être choisi dans le groupe incluant le TiN, le TiAIN ou le TaN.

Avantageusement, l'épaisseur de l'isolant de protection 123 est au moins égale à la moitié de la longueur de grille Lg. L'isolant de protection 123 peut par exemple être choisi dans le groupe comprenant le SiN, le BN, le SiBCN ou le SiBN.

Avantageusement, la couche d'encapsulation 115 est réalisée en oxyde de silicium.

La couche isolante 113 doit être suffisamment épaisse pour limiter la densité des états d'interface. La couche isolante 113 doit également être suffisamment fine pour ne pas accroître excessivement la résistance à la conduction par effet tunnel.

La couche isolante 113 présente avantageusement une épaisseur au moins égale à 0,8nm, de préférence au moins égale à 1nm. La couche isolante 113 présente avantageusement une épaisseur au plus égale à 3nm, de préférence au plus égale à 2,5nm.

Pour une couche isolante 113 formée d'une unique couche homogène, on peut par exemple envisager :
- du La₂O₃ pour une source 131 et un drain 132 de type n. L'épaisseur de cette couche 113 est par exemple comprise entre 1 et 1,5nm, et par exemple de 1,2nm ;
- du TiO₂ pour une source 131 et un drain 132 de type p. L'épaisseur de cette couche 113 est par exemple comprise entre 1 et 1,5nm, et par exemple de 1,1nm.

Pour une couche isolante 113 formée d'un empilement de couches isolantes, on peut par exemple envisager :
- du SiO₂ sur un oxyde de lanthane, ou du TiO₂ sur du Al₂O₃ pour une source 131 et un drain 132 de type n. L'épaisseur de cette couche 113 est par exemple comprise entre 1,5 et 2,5nm, et par exemple de 2nm. On peut par exemple superposer une couche de 1 nm de SiO₂ sur une couche d'oxyde de lanthane de 1nm, ou une couche de 1,3nm de TiO₂ sur une couche de 0,7 nm de Al₂O₃ ;
- du SiO₂ sur un oxyde d'aluminium pour une source 131 et un drain 132 de type p. L'épaisseur de cette couche 113 est par exemple comprise entre 1,5 et 2,5nm, et par exemple de 2nm. On peut par exemple superposer une couche de 1 nm de SiO₂ sur une couche d'oxyde d'aluminium de 1nm.

La couche d'arrêt de gravure 112 peut par exemple être réalisée en SiN. Cette couche 112 peut par exemple présenter une épaisseur comprise entre 5nm et 100nm, typiquement de 20nm.

La couche d'encapsulation 111 peut par exemple être réalisée en oxyde de silicium ou dans un dérivé carboné à faible permittivité. La couche d'encapsulation 111 peut par exemple présenter une épaisseur comprise entre 50nm et 500nm, typiquement de 100nm.

Les figures 2 à 16 illustrent différentes étapes d'un exemple de procédé de fabrication d'un transistor 1 selon le premier mode de réalisation de l'invention.

Dans une configuration initiale illustrée à la figure 2, on dispose d'un composant précurseur du transistor 1, comprenant : un substrat 100 tel que décrit précédemment, une couche isolante enterrée 102 telle que décrite précédemment, des tranchées d'isolation 101 telles que décrites précédemment, un élément semi-conducteur 130 tel que décrit précédemment, un empilement de grille comportant des espaceurs 120 et un isolant de grille 121 tel que décrit précédemment.

Un plot métallique 125 est ménagé sur l'oxyde de grille 121, entre les espaceurs 120. L'extrémité supérieure du plot 125 est affleurante. Une couche d'arrêt de gravure 110 s'étend jusqu'à l'extrémité supérieure des espaceurs 120. La couche d'arrêt de gravure est recouverte par une couche d'encapsulation 115.

Dans la configuration de la figure 3, on a effectué un retrait sélectif partiel d'une partie supérieure du plot métallique 125, pour former l'électrode de grille 122.

On peut par exemple envisager de retirer entre 20 et 80% de la hauteur initiale du plot métallique 125, par exemple 50% de cette hauteur initiale.

Le retrait sélectif peut être effectué par une étape de gravure partielle humide (par exemple avec du TMAH pour du PolySilicium) ou une étape de gravure partielle sèche (par exemple par plasma). Une telle gravure est sélective par rapport au matériau des espaceurs 120 ou de la couche d'encapsulation 115 par exemple.

Optionnellement et dans le cas particulier d'un plot 125 incluant une couche de polysilicium GF, l'électrode de grille 122 peut être soumise à une étape de siliciuration, afin de former par exemple un siliciure choisi dans le groupe comprenant le NiSi, le NiPtSi, le NiCoSi, le TiSi₂ et le WSi.

Dans la configuration de la figure 4, on a formé une couche 103 d'isolant. La couche 103 vient notamment remplir le volume retiré du plot 125 durant l'étape de retrait sélectif. La couche 103 peut être formée par différents procédés tels que le PECVD, le LPCVD ou l'ALD. Pour garantir le comblement du volume de plot 125 retiré, la couche 103 est déposée de façon à recouvrir également la couche d'encapsulation 115.

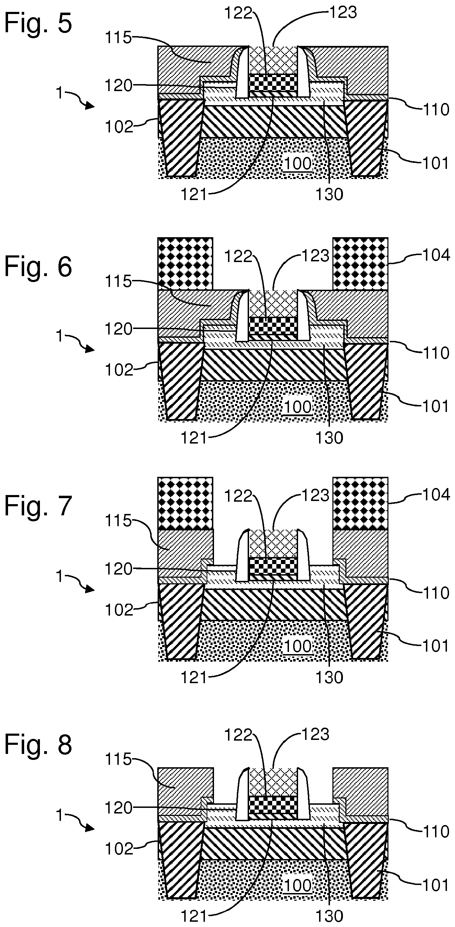

Dans la configuration de la figure 5, on a procédé au retrait de l'excès de la couche 103 jusqu'à découvrir la couche d'encapsulation 115. Ce retrait est typiquement réalisé par un polissage mécano chimique (désigné par l'acronyme CMP dans la littérature). Un tel polissage peut avantageusement être mis en oeuvre avec une sélectivité par rapport aux matériaux autres que celui de la couche 103. A l'issue du retrait, la couche 103 n'est conservée que dans l'empilement de grille, un isolant de protection 123 étant alors formé.

Dans la configuration de la figure 6, on a formé un masque 104 sur la couche d'encapsulation 115, par photolithographie d'une résine par exemple. Le masque 104 est ouvert pour découvrir l'empilement de grille et des zones de la couche d'encapsulation 115 à l'aplomb de la source 131 et du drain 132. L'ouverture ménagée par photolithographie dans le masque 104 présente ainsi une dimension relativement importante par rapport à l'échelle du transistor 1 à former.

Dans la configuration de la figure 7, on a retiré la couche d'encapsulation 115 et la couche d'arrêt de gravure 110 à l'aplomb de la source 131, du drain 132 et de l'empilement de grille. Ce retrait est ici effectué selon le motif défini par l'ouverture du masque 104. Le retrait inclut avantageusement :
- une première étape de gravure, par gravure sélective de la couche d'encapsulation par rapport aux autres matériaux (en particulier les matériaux des espaceurs 120 et de l'isolant de protection 123). Cette gravure est par exemple de type anisotrope, et ses propriétés sont connues en soi de l'homme du métier. Cette gravure est interrompue après avoir retiré la couche d'encapsulation 115 à l'aplomb de la couche d'arrêt de gravure 110 ;
- une deuxième étape de gravure, par gravure sélective de la couche d'arrêt de gravure 110 par rapport aux autres matériaux. Cette gravure est par exemple de type anisotrope, et ses propriétés sont connues en soi de l'homme du métier. Cette gravure est interrompue après avoir retiré la couche d'arrêt de gravure 110 de la source 131, du drain 132 et des espaceurs 120. Des gorges sont ainsi formées à l'aplomb de la source 131 et du drain 132, entre la couche d'encapsulation 115 et les espaceurs 120. Lesdites gorges ont une profondeur typique de 20nm.

Dans la configuration de la figure 8, on a retiré le masque 104 par un procédé connu en soi. Le retrait du masque 104 découvre la face supérieure de la couche d'encapsulation 115.

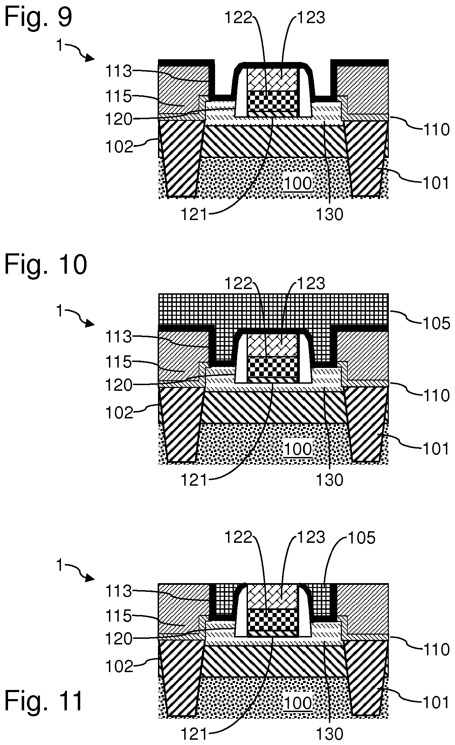

Dans la configuration de la figure 9, on a formé l'isolant électrique 113 pleine plaque. L'isolant électrique 113 recouvre ainsi l'empilement de grille, la source 131, le drain 132 et les parois latérales et supérieures de la couche d'encapsulation 115. L'isolant électrique 113 peut être obtenu soit par formation d'une couche isolante simple, soit par formation d'une superposition de couches isolantes. Les paramètres de formation des matériaux de l'isolant 113 cités précédemment sont connus en soi de l'homme du métier.

Dans la configuration de la figure 10, une couche métallique 105 est formée pleine plaque pour recouvrir l'isolant 113 et remplir les gorges ménagées à l'aplomb de la source 131 et du drain 132.

La couche métallique 105 peut inclure une couche, ou plusieurs couches de métaux différents superposées. Le ou les métaux de ces couches peuvent par exemple être choisis dans le groupe comprenant le TiN, le TaN, le TiAIN, le W ou le Cu.

Dans la configuration de la figure 11, on a procédé au retrait de l'excès de la couche 105 et procédé au retrait d'une partie de la couche isolante 113, jusqu'à découvrir la face supérieure de la couche d'encapsulation 115 et jusqu'à découvrir l'isolant de protection 123 (de façon à éviter un court-circuit entre la source 131 et le drain 132 au-dessus de l'empilement de grille). Ce retrait est typiquement réalisé par un polissage mécano chimique (désigné par l'acronyme CMP dans la littérature). On conserve également une épaisseur de l'isolant de protection 123 suffisante pour garantir une absence de court-circuit entre l'électrode de grille 122 et les contacts de source et de drain. A l'issue du retrait, la couche 105 n'est conservée que dans les gorges délimitées par la couche isolante 113. Une partie inférieure des contacts de grille et de drain est ainsi formée.

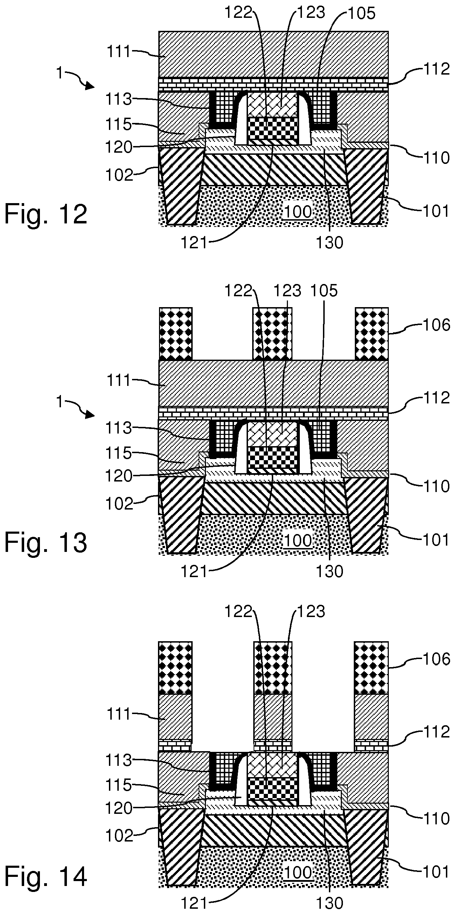

Dans la configuration de la figure 12, on a procédé à la formation :
- d'une couche d'arrêt de gravure 112 pleine plaque ; et
- d'une couche d'encapsulation 111 pleine plaque sur la couche d'arrêt de gravure 112.

Dans la configuration de la figure 13, on a formé un masque 106 sur la couche d'encapsulation 111, par photolithographie d'une résine par exemple. Le masque 106 est ouvert pour découvrir la couche d'encapsulation 111 à l'aplomb de la source 131 et du drain 132. Les ouvertures sont plus larges que la source et le drain, de façon à faciliter leur positionnement à l'aplomb de la source et du drain même avec des tolérances de photolithographie réduites. Les dispersions de positionnement des ouvertures du masque 106 par rapport à la source 131 et au drain 132 peuvent être relativement élevées (par exemple de l'ordre de 0,5*Lg) sans altérer le fonctionnement du transistor 1, du fait de la possibilité de pouvoir déposer ensuite du métal d'un contact jusque sur l'isolant de protection 123, sans risquer de générer un court-circuit.

Dans la configuration de la figure 14, on a retiré la couche d'encapsulation 111 et la couche d'arrêt de gravure 112 à l'aplomb de la source 131 et du drain 132. Ce retrait est ici effectué selon le motif défini par les ouvertures du masque 106. Du fait des ouvertures du masque 106 plus larges que la source 131 et que le drain 132, le retrait découvre ici notamment une partie de la surface supérieure de la couche d'encapsulation 115 et/ou une partie de l'isolant de protection 123.

Le retrait inclut avantageusement :
- une première étape de gravure, par gravure sélective de la couche d'encapsulation 111 par rapport aux autres matériaux (en particulier le matériau de la couche d'arrêt de gravure 112). Cette gravure est par exemple de type anisotrope, et ses propriétés sont connues en soi de l'homme du métier. Cette gravure est interrompue après avoir retiré la couche d'encapsulation 111 à l'aplomb de la couche d'arrêt de gravure 112 ;
- une deuxième étape de gravure, par gravure sélective de la couche d'arrêt de gravure 112 par rapport aux autres matériaux. Cette gravure est par exemple de type anisotrope, et ses propriétés sont connues en soi de l'homme du métier. Cette gravure est interrompue après avoir retiré la couche d'arrêt de gravure 112 de la source 131, du drain 132, des espaceurs 120 et d'une partie de la surface supérieure de la couche d'encapsulation 115. Des gorges sont ainsi formées à l'aplomb de la source 131 et du drain 132, et à l'aplomb d'une partie de la couche d'encapsulation 115, des espaceurs 120 et éventuellement d'une partie de l'isolant de protection 123.

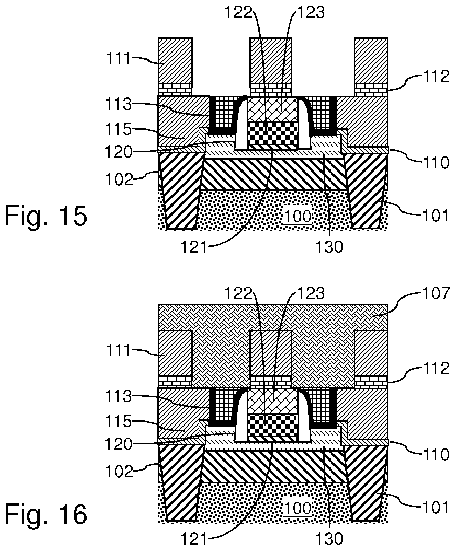

Dans la configuration de la figure 15, on a retiré le masque 106 par un procédé connu en soi. Le retrait du masque 106 découvre la face supérieure de la couche d'encapsulation 111.

Dans la configuration de la figure 16, une couche métallique 107 est formée pleine plaque pour recouvrir les différentes zones et remplir les gorges ménagées à l'aplomb de la source 131 et du drain 132 au-dessus du métal déjà présent. La couche métallique 107 formée est en contact avec la partie inférieure des contacts (formée durant les étapes précédentes) et permet une conduction électrique avec ces contacts.

La couche métallique 107 peut inclure une couche, ou plusieurs couches de métaux différents superposées. Le ou les métaux de ces couches peuvent par exemple être choisis dans le groupe comprenant le TiN, le TaN, le TiAIN, le W ou le Cu. Dans la variante illustrée à la figure 16, le matériau de la couche métallique 107 est différent du métal déjà présent.

Par une étape de retrait de l'excès de la couche métallique 107 jusqu'à découvrir la face supérieure de la couche d'encapsulation 111, on obtient la structure illustrée à la figure 1. Ce retrait est typiquement réalisé par un polissage mécano chimique (désigné par l'acronyme CMP dans la littérature). Les contacts 141 et 142 sont ainsi formés.

Les contacts 141 et 142 obtenus à l'issue de cette étape de retrait peuvent typiquement présenter une épaisseur comprise entre 20 et 500nm, par exemple de 100nm.

Des étapes d'interconnexion connues en soi peuvent ensuite être mises en oeuvre pour raccorder les contacts 141 et 142 du transistor 1 à d'autres circuits.

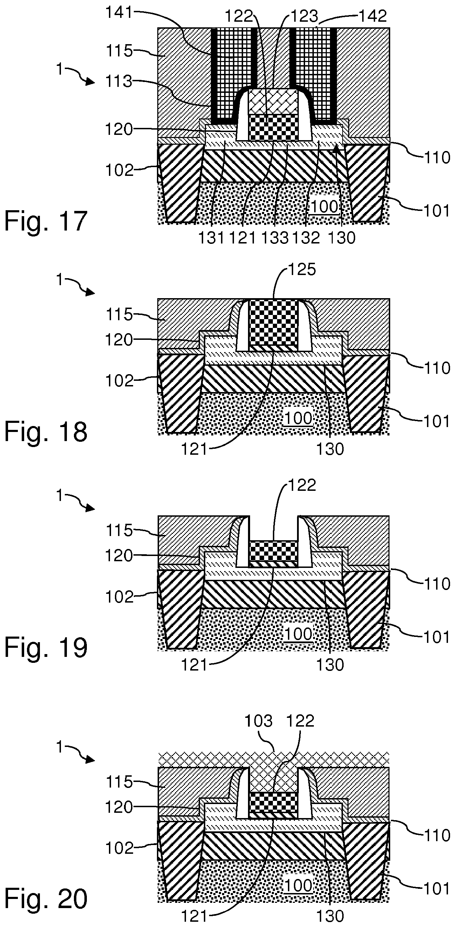

La figure 17 est une vue en coupe d'un exemple de transistor 1 de type FDSOI selon un exemple d'un deuxième mode de réalisation de l'invention. Le transistor 1 comporte de façon connue en soi un substrat semi-conducteur 100 surmonté par une couche d'isolant enterrée 102.

La couche d'isolant enterrée 102 est surmontée par un élément semi-conducteur 130 à base de silicium présentant ici la même structure que dans le premier mode de réalisation. Une source 131, un drain 132 et un canal 133 sont ainsi ménagés dans l'élément 130. Le transistor 1 comporte un empilement de grille disposé au-dessus du canal 133 et présentant ici la même structure que dans le premier mode de réalisation. L'empilement de grille comporte donc ici un isolant électrique de grille 121, une électrode de grille 122, et un isolant électrique 123 de protection de l'électrode de grille 122. Des espaceurs 120 sont avantageusement disposés de part et d'autre latéralement par rapport à l'isolant électrique de grille 121, par rapport à l'électrode de grille 122 et par rapport à l'isolant de protection 123.

Des contacts métalliques 141 et 142 sont disposés respectivement à l'aplomb de la source 131 et du drain 132. Les contacts métalliques 141 et 142 s'étendent en continu jusqu'à l'aplomb de l'empilement de grille. Dans le mode de réalisation illustré, les contacts métalliques 141 et 142 sont disposés au moins partiellement à l'aplomb d'espaceurs 120 respectifs.

Une couche d'isolant électrique 113 est ici disposée entre le contact métallique 141 et la source 131 d'une part, et entre le contact métallique 142 et drain 132 d'autre part.

Comme dans le premier mode de réalisation, l'isolant de protection 123 permet d'éviter un court-circuit entre l'électrode de grille 122 et le contact 141 ou le contact 142, et ce malgré que ces contacts 141 et 142 s'étendent à l'aplomb de l'empilement de grille. Ainsi, le fonctionnement du transistor 1 n'est pas non plus altéré par d'éventuelles dispersions de positionnement des contacts 141 et 142 par rapport à l'empilement de grille. Le positionnement des contacts 141 et 142 garantit des distances minimales entre le canal 133 d'une part et la source 131 et le drain 132 d'autre part, ce qui permet de réduire la résistance de conduction du transistor 1.

Comme pour le premier mode de réalisation, la source 131 et le drain 132 sont avantageusement non siliciurés (pour faciliter l'industrialisation du transistor 1), le gain de résistance de contact obtenu par l'intermédiaire de l'isolant 113 restant significatif du fait de la mise en oeuvre de l'invention. La présence de l'isolant 113 permet également d'éviter une formation de composés intermétalliques dans la source 131 et le drain 132 par diffusion du métal des contacts 141 et 142.

Par ailleurs, les transistors ainsi formés présentent des dispersions relativement réduites de leur résistance d'accès.

Selon l'invention, la couche d'isolant électrique 113 recouvre au moins partiellement l'empilement de grille. L'isolant électrique 113 recouvre ici la partie supérieure des espaceurs 120, sans recouvrir intégralement l'isolant de protection 123.

L'isolant électrique 113 peut être adapté à des connexions de type MIIS, en comportant de façon connue en soi deux films isolants (non détaillés dans les figures) en matériaux différents et superposés.

Ce deuxième mode de réalisation vise à simplifier le processus de fabrication du transistor 1 en limitant notamment au maximum le nombre d'étapes mises en oeuvre, en particulier des étapes de photolithographie et/ou de dépôt.

Le transistor 1 comporte optionnellement des tranchées d'isolation 101 présentant la même structure que dans le premier mode de réalisation.

Une couche d'arrêt de gravure 110 recouvre ici les bords de l'élément 130. La couche d'arrêt de gravure 110 s'étend ici sur les tranchées d'isolation 101, et jusqu'à la partie supérieure de l'élément semi-conducteur 130. La couche d'arrêt de gravure 110 présente une composition connue en soi. Le transistor 1 comporte ici une couche d'encapsulation 115 recouvrant la couche d'arrêt de gravure 110.

L'isolant électrique 113 est ici en contact avec des faces latérales délimitées dans la couche d'encapsulation 115. L'isolant électrique 113 est ici également en contact avec une bordure latérale de la couche d'arrêt de gravure 110.

Les figures 18 à 25 illustrent différentes étapes d'un exemple de procédé de fabrication d'un transistor 1 selon le deuxième mode de réalisation de l'invention. Les étapes illustrées en référence aux figures 18 à 21 peuvent être identiques à celles décrites pour le premier mode de réalisation.

Dans une configuration initiale illustrée à la figure 18, on dispose d'un composant précurseur du transistor 1, comprenant : un substrat 100 tel que décrit précédemment, une couche isolante enterrée 102 telle que décrite précédemment, des tranchées d'isolation 101 telles que décrites précédemment, un élément semi-conducteur 130 tel que décrit précédemment, un empilement de grille comportant des espaceurs 120 et un isolant de grille 121 tel que décrit précédemment.

Un plot métallique 125 est ménagé sur l'oxyde de grille 121, entre les espaceurs 120. L'extrémité supérieure du plot 125 est affleurante. Une couche d'arrêt de gravure 110 s'étend jusqu'à l'extrémité supérieure des espaceurs 120. La couche d'arrêt de gravure est recouverte par une couche d'encapsulation 115.

Dans la configuration de la figure 19, on a effectué un retrait sélectif partiel de la partie supérieure du plot métallique 125, pour former l'électrode de grille 122.

Dans la configuration de la figure 20, on a formé une couche 103 d'isolant. La couche 103 vient notamment remplir le volume retiré du plot 125 durant l'étape de retrait sélectif. Pour garantir le comblement du volume de plot 125 retiré, la couche 103 est déposée de façon à recouvrir également la couche d'encapsulation 115.

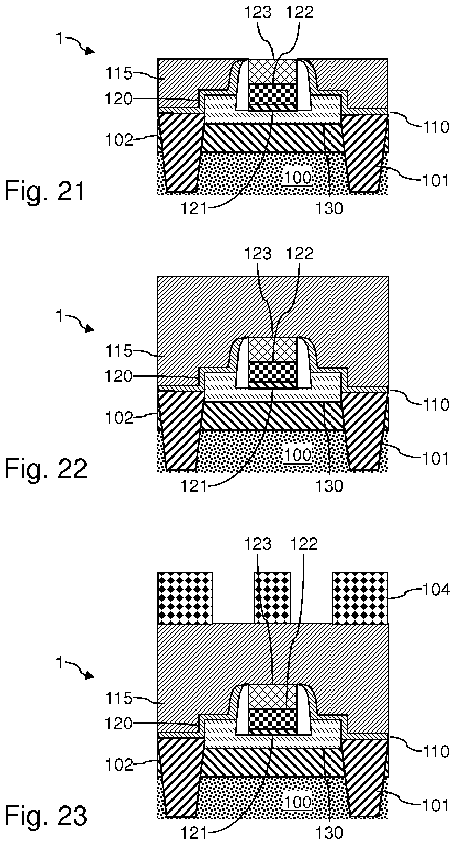

Dans la configuration de la figure 21, on a procédé au retrait de l'excès de la couche 103 jusqu'à découvrir la couche d'encapsulation 115. A l'issue du retrait, la couche 103 n'est conservée que dans l'empilement de grille, un isolant de protection 123 étant alors formé.

Dans la configuration de la figure 22, on a procédé à la formation d'une couche d'encapsulation sur l'empilement de grille et sur la couche d'encapsulation 115 déjà présente. Dans un souci de simplification, une unique couche d'encapsulation 115 est illustrée.

Dans la configuration de la figure 23, on a formé un masque 104 sur la couche d'encapsulation 115, par photolithographie d'une résine par exemple. Le masque 104 est ouvert pour découvrir des zones de la couche d'encapsulation 115 à l'aplomb de la source 131 et du drain 132. Le masque 104 recouvre ici la majeure partie de l'empilement de grille.

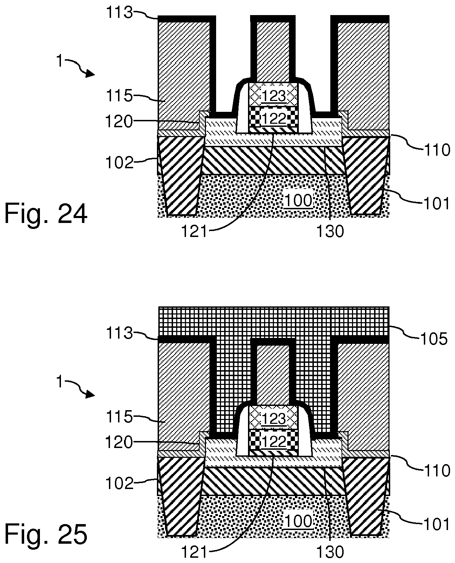

Dans la configuration de la figure 24, on a retiré la couche d'encapsulation 115 et la couche d'arrêt de gravure 110 à l'aplomb de la source 131 et du drain 132. Ce retrait est ici effectué selon le motif défini par l'ouverture du masque 104. Le retrait inclut avantageusement :
- une première étape de gravure, par gravure sélective de la couche d'encapsulation 115 par rapport aux autres matériaux (en particulier les matériaux des espaceurs 120 et de l'isolant de protection 123). Cette gravure est par exemple de type anisotrope, et ses propriétés sont connues en soi de l'homme du métier. Cette gravure est interrompue après avoir retiré la couche d'encapsulation 115 à l'aplomb de la couche d'arrêt de gravure 110 ;
- une deuxième étape de gravure, par gravure sélective de la couche d'arrêt de gravure 110 par rapport aux autres matériaux. Cette gravure est par exemple de type anisotrope, et ses propriétés sont connues en soi de l'homme du métier. Cette gravure est interrompue après avoir retiré la couche d'arrêt de gravure 110 de la source 131, du drain 132 et des espaceurs 120. Des gorges sont ainsi formées à l'aplomb de la source 131 et du drain 132, entre la couche d'encapsulation 115 et les espaceurs 120.

Dans la configuration de la figure 24, on a également retiré le masque 104 par un procédé connu en soi. Le retrait du masque 104 découvre la face supérieure de la couche d'encapsulation 115.

Dans la configuration de la figure 24, on a également formé l'isolant électrique 113 pleine plaque. L'isolant électrique 113 recouvre ainsi l'empilement de grille, la source 131, le drain 132 et les parois latérales et supérieures de la couche d'encapsulation 115. L'isolant électrique 113 recouvre notamment toute la surface des gorges formées à l'aplomb de la source 131 et du drain 132.

L'isolant électrique 113 peut être obtenu soit par formation d'une couche isolante simple, soit par formation d'une superposition de couches isolantes. Les paramètres de formation des matériaux de l'isolant 113 cités précédemment sont connus en soi de l'homme du métier.

Dans la configuration de la figure 25, une couche métallique 105 est formée pleine plaque pour recouvrir l'isolant 113 et remplir les gorges ménagées à l'aplomb de la source 131 et du drain 132.

La couche métallique 105 peut inclure une couche, ou plusieurs couches de métaux différents superposées. Le ou les métaux de ces couches peuvent par exemple être choisis dans le groupe comprenant le TiN, le TaN, le TiAIN, le W, le Co ou le Cu.

Ensuite, une étape de retrait de l'excès de la couche 105 et de retrait d'une partie de la couche isolante 113 est mise en oeuvre, jusqu'à découvrir la face supérieure de la couche d'encapsulation 115. Ce retrait est typiquement réalisé par un polissage mécano chimique (désigné par l'acronyme CMP dans la littérature). A l'issue du retrait, la couche 105 n'est conservée que dans les tranchées délimitées par la couche isolante 113. Les contacts 141 et 142 sont ainsi formés. Les contacts 141 et 142 obtenus à l'issue de cette étape de retrait peuvent typiquement présenter une épaisseur comprise entre 20 et 500nm, par exemple de 100nm.

La couche isolante 113 et l'isolant de protection 123 garantissent une absence de court-circuit entre l'électrode de grille 122 et les contacts 141 et 142.

Des étapes d'interconnexion connues en soi peuvent ensuite être mises en oeuvre pour raccorder les contacts 141 et 142 du transistor 1 à d'autres circuits.

Dans les modes de réalisation illustrés, l'élément semi-conducteur 130 est avantageusement à base de silicium. Un élément semi-conducteur à base de silicium désignera au sens de l'invention un élément semi-conducteur dans laquelle la concentration en silicium est au moins égale à 50 %.

Dans les modes de réalisation illustrés, l'invention est mise en oeuvre à la fois pour la source et pour le drain. On peut également envisager de mettre en oeuvre l'invention avec seulement un contact métallique disposé à l'aplomb de l'empilement de grille, seule la source ou le drain disposant alors d'une réduction de la résistance d'accès.

Dans les modes de réalisation illustrés, la couche d'isolant enterrée est formée sur le substrat. L'invention s'applique également à d'autres structures à contrôle de tension de seuil par grille arrière ou par plan de masse. Dans de telles structures par contrôle à grille arrière :
- la couche isolante enterrée est du type UTBOX, avec une épaisseur typiquement comprise entre 5 et 50 nm ;
- la grille arrière est positionnée entre le substrat et la couche isolante enterrée et présente un dopage très supérieur à celui du substrat ;
- la grille arrière peut être polarisée à un potentiel différent de celui du substrat.

L'invention a été illustrée en référence à un exemple de transistor de type FDSOI. L'invention peut bien entendu s'appliquer à toute autre structure de transistor de type FDSOI. Bien que l'exemple illustré porte sur un transistor de type FDSOI, l'invention peut également s'appliquer à tout autre type de transistor, par exemple un transistor de type PDSOI.

Plus généralement, l'invention s'applique à tout type de transistor à effet de champ présentant un empilement de grille, une source, un drain et des espaceurs. Sont donc concernés les architectures DGFET (Double Grille), TGFET (Triple Grille) et GAAFET (Grille Enrobante) sur substrat massif ou présentant un oxyde enterré.

L'invention s'applique de plus à tout type de semiconducteur par exemple Si, Ge, SiₓGe_{y} ainsi qu'aux III-V (InGaAs, InP, GaAs).

## Revendications

1. Transistor à effet de champ, comportant :
- une source (131), un drain (132) et un canal (133) formés dans une couche semi-conductrice (130) ;
- un empilement de grille disposé au-dessus du canal (133), comprenant une électrode métallique (122), une première couche d'isolant électrique (121) disposée entre l'électrode métallique (122) et le canal (133), et une deuxième couche d'isolant électrique (123) recouvrant l'électrode métallique (122) ;
- un contact métallique (141) disposé à l'aplomb de la source (131) ou du drain (132) et au moins partiellement à l'aplomb dudit empilement de grille ; le transistor à effet de champ étant **caractérisé en ce qu'**il comporte :
- une troisième couche d'isolant électrique (113) disposée entre ledit contact métallique (141) et ladite source (131) ou ledit drain (132), ladite troisième couche d'isolant électrique (113) étant configurée de façon à former un contact électrique par conduction par effet tunnel entre ledit contact métallique (141) et ladite source (131) ou ledit drain (132),
et **en ce que** ladite troisième couche d'isolant électrique (113) recouvre au moins partiellement ledit empilement de grille sans recouvrir intégralement la deuxième couche d'isolant électrique (123).

2. Transistor (1) selon la revendication 1, dans lequel ledit empilement de grille comporte au moins un espaceur (120) disposé latéralement par rapport à ladite première couche d'isolant électrique (121), par rapport à ladite électrode métallique (122) et par rapport à ladite deuxième couche d'isolant électrique (123), ledit contact métallique (141) et ladite troisième couche d'isolant électrique (113) étant disposés au moins partiellement à l'aplomb dudit espaceur (120).

3. Transistor (1) selon l'une quelconque des revendications précédentes, dans lequel ladite troisième couche d'isolant électrique (113) comporte deux films en matériaux différents et superposés.

4. Transistor (1) selon l'une quelconque des revendications précédentes, dans lequel ladite source (131) et ledit drain (132) sont ménagés dans du semi-conducteur non allié à un métal.

5. Transistor (1) selon l'une quelconque des revendications précédentes, dans lequel ladite troisième couche d'isolant électrique (113) présente une épaisseur comprise entre 0.5 et 8 nm au niveau de son contact avec ladite source (131) ou ledit drain (132).

6. Transistor (1) selon l'une quelconque des revendications précédentes, comprenant :
- un autre contact métallique (142) disposé à l'aplomb de l'autre parmi la source (131) ou le drain (132), et au moins partiellement à l'aplomb dudit empilement de grille ;
- une quatrième couche d'isolant électrique (113) disposée entre ledit autre contact métallique et ladite autre parmi la source ou le drain (132), ladite quatrième couche d'isolant électrique (113) étant configurée de façon à former un contact électrique par conduction par effet tunnel entre ledit contact métallique (141) et ladite autre parmi la source (131) ou le drain (132), ladite quatrième couche d'isolant électrique (113) recouvrant au moins partiellement ledit empilement de grille.

7. Procédé de fabrication d'un transistor à effet de champ (1), comprenant les étapes de :
- fournir un ensemble comprenant :
- une couche semi-conductrice (130) dans laquelle une source (131), un drain (132) et un canal (133) sont formés ;
- un empilement de grille disposé au-dessus du canal (133), et comprenant une électrode métallique (122), une première couche d'isolant électrique (121) disposée entre l'électrode métallique (122) et le canal (133), et une deuxième couche d'isolant électrique (123) recouvrant l'électrode métallique (122) ;
- une troisième couche d'isolant électrique (113) recouvrant au moins partiellement ledit empilement de grille sans recouvrir intégralement la deuxième couche d'isolant électrique (123) ;
- former un contact métallique (141, 142) sur ladite troisième couche d'isolant électrique (113) à l'aplomb de la source (131) ou du drain (132), ladite troisième couche d'isolant électrique (113) étant configurée de façon à former un contact électrique par conduction par effet tunnel entre ledit contact métallique (141, 142) et ladite source (131) ou ledit drain (132), et former ledit contact métallique (141, 142) au moins partiellement à l'aplomb dudit empilement de grille, la troisième couche d'isolant électrique (113) étant alors disposée entre ledit contact métallique (141, 142) et ladite source (131) et ledit drain (132).

8. Procédé de fabrication selon la revendication 7, dans lequel :
- ledit empilement de grille fourni comporte au moins un espaceur (120) disposé latéralement par rapport à ladite première couche d'isolant électrique (121), par rapport à ladite électrode métallique (122) et par rapport à ladite deuxième couche d'isolant électrique (123) ; et
- ledit contact métallique (141) et ladite troisième couche d'isolant électrique (113) étant formés au moins partiellement à l'aplomb dudit espaceur (120).

9. Procédé de fabrication selon la revendication 8, comprenant :
- une étape préalable de formation de ladite électrode métallique (122) par retrait d'une partie d'un plot métallique (125) disposé latéralement par rapport audit espaceur (120) ;
- une étape préalable de dépôt de ladite deuxième couche d'isolant électrique (123) sur ladite électrode métallique (122).

10. Procédé de fabrication selon l'une quelconque des revendications 7 à 9, dans lequel :
- ledit ensemble fourni comporte une couche d'encapsulation (115) comportant une ouverture traversante ménagée à l'aplomb de l'empilement de grille et à l'aplomb de la source (131) et du drain (132), des gorges étant ménagées de part et d'autre de l'empilement de grille et délimitées latéralement par ladite couche d'encapsulation (115), le fond desdites gorges étant délimité respectivement par ladite source (131) et par ledit drain (132) ;
- le procédé comprend des étapes préalables de :
- former ladite troisième couche d'isolant électrique (113) de façon à recouvrir au moins le fond desdites gorges ;
- former au moins une première partie dudit contact métallique (141) par apport de métal dans au moins une desdites gorges.

11. Procédé de fabrication selon la revendication 10, comprenant en outre les étapes de :
- former ladite troisième couche d'isolant électrique (113) de façon à recouvrir ladite couche d'encapsulation (115) et ledit empilement de grille ;
- retirer ladite troisième couche d'isolant électrique (113) d'une face supérieure de la couche d'encapsulation (115) et de l'empilement de grille ; puis
- former une deuxième partie dudit contact métallique (141) par apport de métal en contact avec ladite première partie dudit contact métallique (141).

12. Procédé de fabrication selon l'une quelconque des revendications 7 à 10, dans lequel :
- ledit ensemble fourni comporte une couche d'encapsulation (115) comportant des ouvertures traversantes ménagées respectivement à l'aplomb de la source (131) et du drain (132), des gorges étant ménagées de part et d'autre de l'empilement de grille et délimitées latéralement par ladite couche d'encapsulation (115), le fond desdites gorges étant délimité respectivement par ladite source (131) et par ledit drain (132) ;
- le procédé comprend des étapes préalables de :
- former ladite troisième couche d'isolant électrique (113) de façon à recouvrir une partie de la couche d'encapsulation (115) recouvrant le fond desdites gorges et des parois latérales desdites gorges et recouvrant au moins partiellement l'empilement de grille ;
- former ledit contact métallique (141) par apport de métal dans au moins une desdites gorges.

13. Procédé de fabrication selon la revendication 12, comprenant en outre une étape postérieure audit apport de métal incluant le retrait de ladite troisième couche d'isolant électrique (113) d'une face supérieure de la couche d'encapsulation (115).

## Patentansprüche

1. Feldeffekttransistor, der aufweist:
- eine Source (131), einen Drain (132) und einen Kanal (133), die in einer Halbleiterschicht (130) geformt sind;
- einen über dem Kanal (133) angeordneten Gatestapel, der eine Metallelektrode (122), eine erste elektrische Isolatorschicht (121), die zwischen der Metallelektrode (122) und dem Kanal (133) angeordnet ist, und eine zweite elektrische Isolatorschicht (123) enthält, die die Metallelektrode (122) bedeckt;
- einen Metallkontakt (141), der lotrecht zur Source (131) oder zum Drain (132) und mindestens teilweise lotrecht zum Gatestapel angeordnet ist;
wobei der Feldeffekttransistor **dadurch gekennzeichnet ist, dass** er aufweist:
- eine dritte elektrische Isolatorschicht (113), die zwischen dem Metallkontakt (141) und der Source (131) oder dem Drain (132) angeordnet ist, wobei die dritte elektrische Isolatorschicht (113) konfiguriert ist, um einen elektrischen Kontakt durch Leitung durch Tunneleffekt zwischen dem Metallkontakt (141) und der Source (131) oder dem Drain (132) zu formen,
und dass die dritte elektrische Isolatorschicht (113) den Gatestapel mindestens teilweise bedeckt, ohne die zweite elektrische Isolatorschicht (123) vollständig zu bedecken.

2. Transistor (1) nach Anspruch 1, wobei der Gatestapel mindestens einen Abstandshalter (120) aufweist, der seitlich bezüglich der ersten elektrischen Isolatorschicht (121), bezüglich der Metallelektrode (122) und bezüglich der zweiten elektrischen Isolatorschicht (123) angeordnet ist, wobei der Metallkontakt (141) und die dritte elektrische Isolatorschicht (113) mindestens teilweise lotrecht zum Abstandshalter (120) angeordnet sind.

3. Transistor (1) nach einem der vorhergehenden Ansprüche, wobei die dritte elektrische Isolatorschicht (113) zwei Folien aus unterschiedlichen Materialien und übereinander angeordnet aufweist.

4. Transistor (1) nach einem der vorhergehenden Ansprüche, wobei die Source (131) und der Drain (132) in nicht mit einem Metall legiertem Halbleiter eingerichtet sind.

5. Transistor (1) nach einem der vorhergehenden Ansprüche, wobei die dritte elektrische Isolatorschicht (113) eine Dicke zwischen 0,5 und 8 nm im Bereich ihres Kontakts mit der Source (131) oder dem Drain (132) aufweist.

6. Transistor (1) nach einem der vorhergehenden Ansprüche, 5 der enthält:
- einen weiteren Metallkontakt (142), der lotrecht zum anderen von der Source (131) oder dem Drain (132) und mindestens teilweise lotrecht zum Gatestapel angeordnet ist;
- eine vierte elektrische Isolatorschicht (113), die zwischen dem weiteren Metallkontakt und dem anderen von der Source oder dem Drain (132) angeordnet ist, wobei die vierte elektrische Isolatorschicht (113) konfiguriert ist, um einen elektrischen Kontakt durch Leitung durch Tunneleffekt zwischen dem Metallkontakt (141) und dem anderen von der Source (131) oder dem Drain (132) zu formen, wobei die vierte elektrische Isolatorschicht (113) den Gatestapel mindestens teilweise bedeckt.

7. Herstellungsverfahren eines Feldeffekttransistors (1), das die Schritte enthält:
- eine Einheit zu liefern, die enthält:
- eine Halbleiterschicht (130), in der eine Source (131), ein Drain (132) und ein Kanal (133) geformt sind;
- einen Gatestapel, der über dem Kanal (133) angeordnet ist und eine Metallelektrode (122), eine erste elektrische Isolatorschicht (121), die zwischen der Metallelektrode (122) und dem Kanal (133) angeordnet ist, und eine zweite elektrische Isolatorschicht (123) enthält, die die Metallelektrode (122) bedeckt;
- eine dritte elektrische Isolatorschicht (113), die den Gatestapel mindestens teilweise bedeckt, ohne die zweite elektrische Isolatorschicht (123) vollständig zu bedecken;
- einen Metallkontakt (141, 142) auf der dritten elektrischen Isolatorschicht (113) lotrecht zur Source (131) oder zum Drain (132) zu formen, wobei die dritte elektrische Isolatorschicht (113) konfiguriert ist, um einen elektrischen Kontakt durch Leitung durch Tunneleffekt zwischen dem Metallkontakt (141, 142) und der Source (131) oder dem Drain (132) formen, und den Metallkontakt (141, 142) mindestens teilweise lotrecht zum Gatestapel zu formen, wobei die dritte elektrische Isolatorschicht (113) dann zwischen dem Metallkontakt (141, 142) und der Source (131) und dem Drain (132) angeordnet ist.

8. Herstellungsverfahren nach Anspruch 7, wobei:
- der gelieferte Gatestapel mindestens einen Abstandshalter (120) aufweist, der seitlich in Bezug auf die erste elektrische Isolatorschicht (121), in Bezug auf die Metallelektrode (122) und in Bezug auf die zweite elektrische Isolatorschicht (123) angeordnet ist; und
- der Metallkontakt (141) und die dritte elektrische Isolatorschicht (113) mindestens teilweise lotrecht zum Abstandshalter (120) geformt sind.

9. Herstellungsverfahren nach Anspruch 8, das enthält:
- einen vorhergehenden Schritt des Formens der Metallelektrode (122) durch Entfernen eines Teils eines Metallblocks (125), der seitlich bezüglich des Abstandshalters (120) angeordnet ist;
- einen vorhergehenden Schritt des Aufbringens der zweiten elektrischen Isolatorschicht (123) auf die Metallelektrode (122).

10. Herstellungsverfahren nach einem der Ansprüche 7 bis 9, wobei:
- die gelieferte Einheit eine Verkapselungsschicht (115) aufweist, die eine Durchgangsöffnung aufweist, die lotrecht zum Gatestapel und lotrecht zur Source (131) und zum Drain (132) eingerichtet ist, wobei Rillen zu beiden Seiten des Gatestapels eingerichtet sind und seitlich von der Verkapselungsschicht (115) begrenzt werden, wobei der Boden der Rillen von der Source (131) bzw. vom Drain (132) begrenzt wird;
- das Verfahren vorhergehende Schritte enthält des:
- Formens der dritten elektrischen Isolatorschicht (113) derart, dass sie mindestens den Boden der Rillen bedeckt;
- Formens mindestens eines ersten Teils des Metallkontakts (141) durch Zufuhr von Metall in mindestens eine der Rillen.

11. Herstellungsverfahren nach Anspruch 10, das außerdem die Schritte enthält des:
- Formens der dritten elektrischen Isolatorschicht (113), um die Verkapselungsschicht (115) und den Gatestapel zu bedecken;
- Entfernens der dritten elektrischen Isolatorschicht (113) von einer Oberseite der Verkapselungsschicht (115) und des Gatestapels; dann
- Formens eines zweiten Teils des Metallkontakts (141) durch Zufuhr von Metall in Kontakt mit dem ersten Teil des Metallkontakts (141).

12. Herstellungsverfahren nach einem der Ansprüche 7 bis 10, wobei:
- die gelieferte Einheit eine Verkapselungsschicht (115) aufweist, die Durchgangsöffnungen aufweist, die lotrecht zur Source (131) bzw. zum Drain (132) eingerichtet sind, wobei Rillen zu beiden Seiten des Gatestapels eingerichtet sind und seitlich von der Verkapselungsschicht (115) begrenzt werden, wobei der Boden der Rillen von der Source (131) bzw. vom Drain (132) begrenzt wird;
- das Verfahren vorhergehende Schritte enthält des:
- Formens der dritten elektrischen Isolatorschicht (113), um einen Teil der Verkapselungsschicht (115) zu bedecken, die den Boden der Rillen und Seitenwände der Rillen bedeckt und den Gatestapel mindestens teilweise bedeckt;
- Formens des Metallkontakts (141) durch Metallzufuhr in mindestens eine der Rillen.

13. Herstellungsverfahren nach Anspruch 12, das außerdem einen Schritt nach der Metallzufuhr enthält, der das Entfernen der dritten elektrischen Isolatorschicht (113) von einer Oberseite der Verkapselungsschicht (115) umfasst.

## Claims

1. Field-effect transistor, comprising:
- a source (131), drain (132) and channel (133) formed in a semiconductor layer (130);
- a gate stack placed above the channel (133), comprising a metal electrode (122), a first layer of electrical insulator (121) placed between the metal electrode (122) and the channel (133), and a second layer of electrical insulator (123) covering the metal electrode (122);
- a metal contact (141) placed plumb with the source (131) or drain (132) and at least partially plumb with said gate stack;
the field-effect transistor being **characterized in that** it comprises:
- a third layer of electrical insulator (113) placed between said metal contact (141) and said source (131) or said drain (132), said third layer of electrical insulator (113) being configured so as to make an electrical contact through conduction via quantum tunnelling between said metal contact (141) and said source (131) or said drain (132),
- and **in that** said third layer of electrical insulator (113) at least partially covers said gate stack without completely covering the second layer of electrical insulator (123).

2. Transistor (1) according to Claim 1, in which said gate stack includes at least one spacer (120) placed laterally relative to said first layer of electrical insulator (121), relative to said metal electrode (122) and relative to said second layer of electrical insulator (123), said metal contact (141) and said third layer of electrical insulator (113) being placed at least partially plumb with said spacer (120).

3. Transistor (1) according to either one of the preceding claims, in which said third layer of electrical insulator (113) includes two superposed films made of different materials.

4. Transistor (1) according to any one of the preceding claims, in which said source (131) and said drain (132) are produced in semiconductor not alloyed with a metal.

5. Transistor (1) according to any one of the preceding claims, in which said third layer of electrical insulator (113) has a thickness comprised between 0.5 and 8 nm level with its contact with said source (131) or said drain (132).

6. Transistor (1) according to any one of the preceding claims, comprising:
- another metal contact (142) placed plumb with the other of the source (131) or drain (132), and at least partially plumb with said gate stack;
- a fourth layer of electrical insulator (113) placed between said other metal contact and said other of the source or drain (132), said fourth layer of electrical insulator (113) being configured so as to make an electrical contact through conduction via quantum tunnelling between said metal contact (141) and said other of the source (131) or drain (132), said fourth layer of electrical insulator (113) at least partially covering said gate stack.

7. Process for fabricating a field-effect transistor (1), comprising the steps of:
- providing an assembly comprising:
- a semiconductor layer (130) in which a source (131), drain (132) and channel (133) are formed;
- a gate stack placed above the channel (133), and comprising a metal electrode (122), a first layer of electrical insulator (121) placed between the metal electrode (122) and the channel (133), and a second layer of electrical insulator (123) covering the metal electrode (122);
- a third layer of electrical insulator (113) at least partially covering said gate stack without completely covering the second layer of electrical insulator (123);
- forming a metal contact (141, 142) on said third layer of electrical insulator (113) plumb with the source (131) or drain (132), said third layer of electrical insulator (113) being configured so as to make an electrical contact through conduction via quantum tunnelling between said metal contact (141, 142) and said source (131) or said drain (132), and forming said metal contact (141, 142) at least partially plumb with said gate stack, the third layer of electrical insulator (113) then being placed between said metal contact (141, 142) and said source (131) and said drain (132).

8. Fabricating process according to Claim 7, in which:
- said provided gate stack includes at least one spacer (120) placed laterally relative to said first layer of electrical insulator (121), relative to said metal electrode (122) and relative to said second layer of electrical insulator (123); and
- said metal contact (141) and said third layer of electrical insulator (113) being formed at least partially plumb with said spacer (120).

9. Fabricating process according to Claim 8, comprising:
- a prior step of forming said metal electrode (122) by removing a portion of a metal pad (125) that is placed laterally relative to said spacer (120);
- a prior step of depositing said second layer of electrical insulator (123) on said metal electrode (122).

10. Fabricating process according to any one of Claims 7 to 9, in which:
- said provided assembly includes an encapsulating layer (115) including a through-aperture produced plumb with the gate stack and plumb with the source (131) and drain (132), grooves being produced on either side of the gate stack and delimited laterally by said encapsulating layer (115), the bottom of said grooves being delimited by said source (131) and by said drain (132), respectively;
- the process comprises prior steps of:
- forming said third layer of electrical insulator (113) so as to cover at least the bottom of said grooves;
- forming at least a first portion of said metal contact (141) by transferring metal into at least one of said grooves.

11. Fabricating process according to Claim 10, furthermore comprising the steps of:
- forming said third layer of electrical insulator (113) so as to cover said encapsulating layer (115) and said gate stack;
- removing said third layer of electrical insulator (113) from an upper face of the encapsulating layer (115) and the gate stack; then
- forming a second portion of said metal contact (141) by transferring metal into contact with said first portion of said metal contact (141).

12. Fabricating process according to any one of Claims 7 to 10, in which:
- said provided assembly includes an encapsulating layer (115) including through-apertures produced plumb with the source (131) and drain (132), respectively, grooves being produced on either side of the gate stack and delimited laterally by said encapsulating layer (115), the bottom of said grooves being delimited by said source (131) and by said drain (132), respectively;
- the process comprises prior steps of:
- forming said third layer of electrical insulator (113) so as to cover a portion of the encapsulating layer (115) covering the bottom of said grooves and sidewalls of said grooves and covering at least partially the gate stack;
- forming said metal contact (141) by transferring metal into at least one of said grooves.

13. Fabricating process according to Claim 12, furthermore comprising a step subsequent to said transfer of metal including removing said third layer of electrical insulator (113) from an upper face of the encapsulating layer (115).
